# EUROPEAN PATENT APPLICATION

(11) **EP 1 577 946 A2**
(43) Date of publication of application: **21.09.2005**
(21) Application number: 05003845.4
(22) Date of filing: 23.02.2005
(51) Int. Cl.: H01L 23/544

(54) **Method to make markers for doublegate SOI processing**

(30) Priority: 17.03.2004 EP 04101087
(71) Applicant: Interuniversitair Microelektronica Centrum, 3001 Leuven (BE); Koninklijke Philips Electronics N.V., 5621 BA Eindhoven (NL)
(72) Inventor: Loo, Josine Johanna Gerarda Petra, 3001 Leuven (BE); Ponomarev, Youri V., 3001 Leuven (BE); Laider, David William, 3001 Leuven (BE)
(74) Representative: Bird, Ariane

(57) **Abstract**

Method to make at least one marker (MX) for double gate SOI processing on a SOI wafer, the at least one marker having a diffracting structure in a first direction and the diffracting structure being arranged for generating an asymmetrical diffraction pattern during use in an alignment and overlay detection system for detection in the first direction;
the SOI wafer comprising a substrate, an oxidized layer on the substrate, and a semiconductor layer on top of the oxidized layer;
the double gate SOI processing being performed on at least one die (D); the at least one die (D) being located on the semiconductor layer and comprising at least an inner area arranged as a circuit area (C) and an outer area arranged as scribe line area (SL); the at least one marker (MX) being defined in the scribe line area (SL); and
the double gate SOI processing comprising a processing step for:
- separating the semiconductor layer from the oxidized layer,
- attaching the separated semiconductor layer as a turned-over semiconductor layer on a surface of a new substrate, with the original top surface of the semiconductor layer directed towards on the surface of the new substrate, wherein the method provides a mirrored marker (MX'), the mirrored marker (MX') being the mirror image of the marker (MX), by using a mirror operation around a second direction perpendicular to the first direction.

## Description

The present invention relates to a method to make a marker for double gate SOI processing as defined in the preamble of claim 1. Also, the present invention relates to a marker for double gate SOI processing. Moreover, the present invention relates to a semiconductor device provided with such a marker for double gate SOI processing.

Such a marker is known from US 6,335,214 B1 which discloses a SOI (silicon-on-insulator) circuit with double-gate transistors. A method for a double-gate transistor is disclosed wherein a back-side gate is created, which is self-aligned to the upper gate of the transistor.

A transfer method is used to generate marking features on the wafer backside comprising the formation of etch stop spacers on the edge of a gate stack and the etching of an alignment trench through the silicon device layer and through the buried oxide layer, so that deposition of an alignment layer on the bottom of the alignment trench provides a marker on the backside.

Since critical features sizes of semiconductor devices are 100 nm and less, in lithographic processing the requirements for (optical) alignment and overlay are high. In lithographic apparatuses, alignment and overlay detection is performed typically by detecting a plurality of diffracted beams (i.e., diffraction orders) generated by an impinging optical beam on an alignment marker.

Such alignment markers may comprise a grating of which the structure is modified in such a way that the intensity of some selected diffracted beams are biased with respect to the other diffracted beams of which the intensity is relatively reduced. Due to the biasing of some selected diffraction orders, the diffraction pattern (i.e., the set of diffraction beams) becomes asymmetrical with respect to the impinging optical beam. By this measure the alignment and overlay detection method is generally improved.

However, the asymmetry of alignment signals and their detection in the lithographic apparatus is an obstacle for double gate SOI processing, where wafer bonding is performed. After wafer bonding, further lithographic processing is hindered since the signals generated by the alignment marker can not be detected anymore due to the disturbed asymmetry.

It is an object of the present invention to provide a method to make a marker for double gate SOI processing, which removes the disadvantage from the prior art.

The present invention relates to:
a method to make at least one marker for double gate SOI processing on a SOI wafer, the at least one marker having a diffracting structure in a first direction and the diffracting structure being arranged for generating an asymmetrical diffraction pattern during use in an alignment and overlay detection system for detection in the first direction;
the SOI wafer comprising a substrate, an oxidized layer on the substrate, and a semiconductor layer on top of the oxidized layer;
the double gate SOI processing being performed on at least one die; the at least one die being located on the semiconductor layer and comprising at least an inner area arranged as a circuit area and an outer area arranged as scribe line area; the at least one marker being defined in the scribe line area; and
the double gate SOI processing comprising a processing step for:
   - separating the semiconductor layer from the oxidized layer,
   - attaching the separated semiconductor layer as a turned-over semiconductor layer on a surface of a new substrate, with the original top surface of the semiconductor layer directed towards the surface of the new substrate, wherein the method provides a mirrored marker, the mirrored marker being the mirror image of the marker, by using a mirror operation around a second direction perpendicular to the first direction.

Advantageously, during further lithographic processing such a second alignment marker, as produced by the method of the present invention, generates the asymmetrical diffraction pattern as required by the alignment and overlay sensor of the lithographic apparatus. Moreover, since the second alignment marker is created during the same step as the creation of the first (original) alignment marker their relative positions are defined. Alignment with the second alignment marker is now straightforward.

Also, the present invention relates to a semiconductor device comprising such a second alignment marker.
Fig. 1 schematically shows a plane view of a die from the prior art;
Fig. 2 schematically shows a plane view of an alignment marker from the prior art;
Fig. 3 schematically shows a plane view of a die comprising alignment markers manufactured according to the present invention;
Fig. 4 schematically shows a plane view of a second alignment marker in accordance with the present invention.

For the purpose of teaching of the invention, preferred embodiments of the method and devices of the invention are described below. It will be appreciated by the person skilled in the art that other alternative and equivalent embodiments of the invention can be conceived and reduced to practice without departing form the true spirit of the invention, the scope of the invention being limited only by the appended claims.

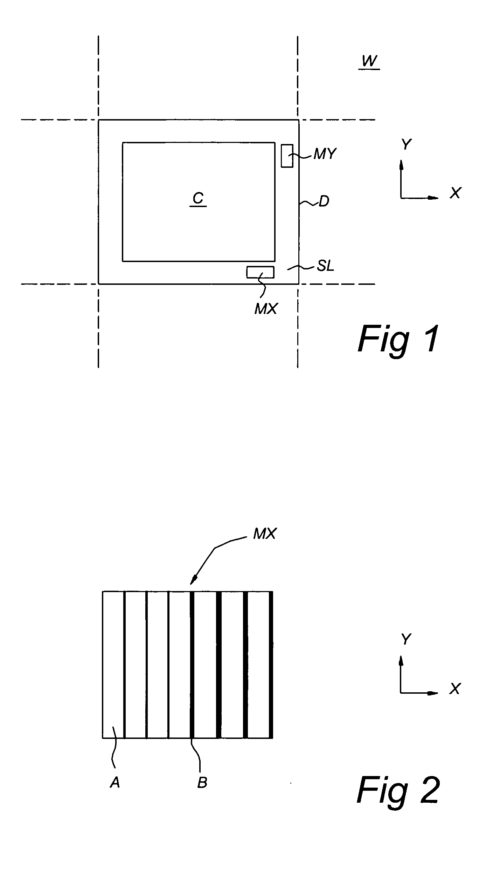

Figure 1 schematically shows a plane view of a die from the prior art. On a semiconductor wafer W semiconductor devices are produced. The wafer estate required for a semiconductor device is a die D. Typically, a die is a substantially rectangular area. The wafer comprises a plurality of dies arranged in a matrix of rows running in a first direction X and columns running in a second perpendicular direction Y.

Within the area of the die D, an inner area C is available for creating electronic circuits which make up the semiconductor device.

Surrounding the inner area is a peripheral area, denoted as the scribe line area SL, which at some point of the manufacturing process will be sacrificed for separating the individual dies form each other.

The scribe line area SL comprises alignment and overlay markers. The alignment and overlay markers are used during a lithographic step in the manufacturing process to allow alignment of features in the die area relative to projection features on a mask. The projection features are to be imaged on a photosensitive layer covering the die area. Next, after projection of the mask image (with the projection features) on the photosensitive layer, development of the layer, and opening of the projection features (e.g. by reactive ion etching), subsequently a step for definition of the projected features (e.g., definition of doped areas, or definition of (semi)conducting or isolating areas, depending on the purpose of the mask) can be carried out.

Typically, alignment is required in both the X and Y direction. Therefore, a first alignment marker MX arranged for alignment in the X-direction and a second alignment marker MY arranged for alignment in the Y-direction are present in the scribe line area SL.

Figure 2 schematically shows a plane view of an alignment marker from the prior art.

Such alignment markers comprise a grating of which the structure is modified in such a way that the intensity of some selected diffracted beams are biased with respect to the other diffracted beams of which the intensity is relatively reduced.

The grating comprises a plurality of first elements A and second elements B, each element type, in use, having a specific interaction with the impinging optical beam. As known to persons skilled in the art, the grating may, for example, comprise as elements A and B lines and trenches etched in the scribe line area SL, or a sequence of lines of different materials A and B.

Due to the specific composition of the grating (width and/or the alternation sequence of elements A and B) the diffraction pattern to be generated by the grating comprises some biased diffraction orders. In Figure 2 the grating is schematically shown to have a variation of the width of the individual elements A and B over the X-direction for generating such a biased diffraction pattern. Moreover, due to the biasing of some selected diffraction orders, the diffraction pattern (i.e., the set of diffraction beams) becomes asymmetrical with respect to the impinging optical beam, i.e., the diffraction orders to be measured are arranged substantially on one side of the normal of the grating surface. (The purpose of providing such an asymmetry relates to properties of the alignment detection system as used in the lithographic apparatus, in this case).

It is noted that first (MX) and second (MY) markers may be identical gratings, but they may differ as well.

During double gate SOI processing, the dies are created on a semiconductor (silicon) layer on top of an oxidized Si substrate (a SOI wafer). At some instance during manufacturing, the semiconductor layer will be separated from the oxidized Si substrate, turned upside down, and by means of wafer bonding be attached with the original top downwards on a new substrate (comprising an oxidized surface layer). For example, the turnover may take place after the creation of the active transistor layer of a double gate transistor (i.e., the top gate plus the Si source, drain and channel areas). In a subsequent step, the second gate can be manufactured on the (then) surface area of the die D.
Due to the turnover of the dies, for example, around the Y axis, the first alignment marker markers MX will be in a mirrored position with respect to their original orientation.

In this mirrored position the first alignment marker MX can not be used properly anymore. The asymmetry of the diffraction pattern causes that diffracted intensity is substantially aimed in another direction than the preferred direction of the optical detector system. Thus, alignment and overlay measurement on such turned-over alignment marker is seriously hindered.

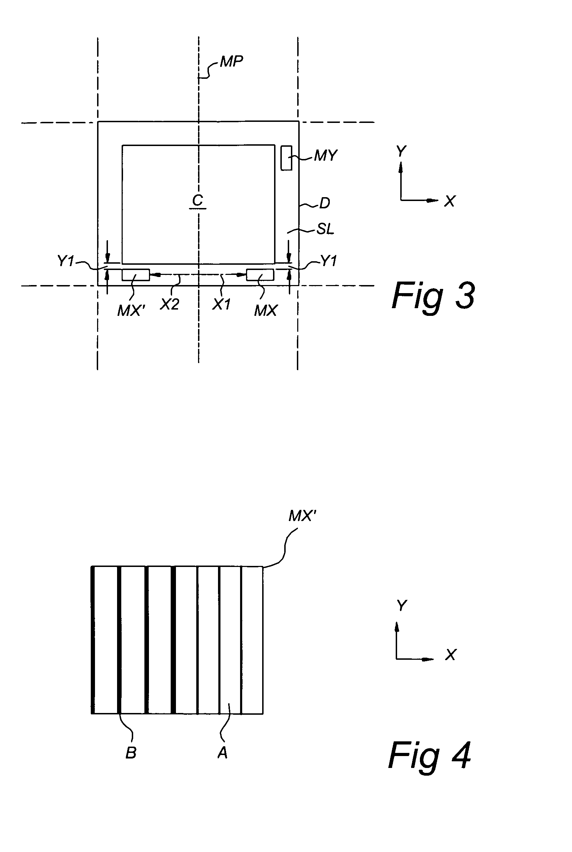

Figure 3 schematically shows a plane view of a die comprising alignment markers manufactured according to the present invention.

In Figure 3 entities with the same reference number refer to identical entities as shown in the preceding figures.

According to the present invention, the method to make a marker (grating) MX for double gate SOI processing provides the creation of a mirrored marker (grating) MX' in the scribe line area SL, wherein such mirrored marker (grating) MX' is the mirror image of the marker MX.

The position of the mirrored marker (grating) MX' in the scribe line area SL is chosen to be mirror-symmetrical with respect to the location of the marker (grating) MX, by applying as mirror line MP the vertical symmetry line of the rectangular envelope of die D. In Figure 3 the grating of mirrored first alignment marker MX' is located on the mirrored position of MX, as defined by the mirror line MP.

Thus, if the grating of MX is located at a horizontal position X1 relative to the mirror plane MP of the die D, then the mirrored grating of MX' is located at a second horizontal position X2, which distance to the mirror plane MP is equal to the distance X1. Further, the vertical position Y1 of MX and Y2 of MX' must be substantially equal.

It is noted that since the first alignment marker MX and the mirrored first alignment marker MX' are created during the same lithographic process, accurate positioning is straightforward.

The second alignment marker MY is not affected by the turn-over of the dies and may still be used for vertical alignment.

Figure 4 schematically shows a plane view of a second alignment marker in accordance with the present invention. The mirrored first alignment marker MX' comprises a structure which is mirrored relative to first alignment marker MX around the vertical direction.
In the specification above the invention is related to double gate SOI processing. It is noted that for other semiconductor device manufacturing methods which may prefer to turn-over a die at some instance, the present invention may also be used.

For example, the present invention may be applied for the manufacturing of heat sinks located at a back-side of a die.

Other applications can be imagined in relation to the possibility to have fully aligned processing on the backside of the original semiconductor device layer. For instance, one can remove the oxidized carrier Si substrate and transfer the semiconductor device layer onto another (e.g., non-Si or highly-resistive Si) substrate to allow fabrication of other components on the backside of the original semiconductor layer. Such components may comprise many types.

For example, quality of RF device components may greatly benefit from such a replacement of the original semiconductor layer with a new non-Si or highly-resistive Si substrate. In this respect, highly-resistive Si may be defined as Si having a resistivity above the standard value of 10-30 : .cm ranging up to values of about 10⁶: .cm).

Other components may be e.g., heat sink components, memory device components, analog device components, and high-voltage device components.

Also, integration with opto-electronic devices may be facilitated by this type of fully aligned processing of a turned-over semiconductor layer.

Persons skilled in the art will appreciate that the present invention is not limited to the aforementioned types of devices, but may be applicable in other electronic and/or micro-mechanic device types as well.

## Claims

1. Method to make at least one marker (MX) for double gate SOI processing on a SOI wafer, the at least one marker having a diffracting structure in a first direction and the diffracting structure being arranged for generating an asymmetrical diffraction pattern during use in an alignment and overlay detection system for detection in said first direction;
the SOI wafer comprising a substrate, an oxidized layer on the substrate, and a semiconductor layer on top of the oxidized layer;
the double gate SOI processing being performed on at least one die (D); the at least one die (D) being located on the semiconductor layer and comprising at least an inner area arranged as a circuit area (C) and an outer area arranged as scribe line area (SL); the at least one marker (MX) being defined in the scribe line area (SL); and
the double gate SOI processing comprising a processing step for:
- separating the semiconductor layer from the oxidized layer,
- attaching the separated semiconductor layer as a turned-over semiconductor layer on a surface of a new substrate, with the original top surface of the semiconductor layer directed towards the surface of the new substrate, wherein the method provides a mirrored marker (MX'), the mirrored marker (MX') being the mirror image of the marker (MX), by using a mirror operation around a second direction perpendicular to said first direction.

2. Method according to claim 1, wherein a position (X2) of the mirrored marker (MX') in the scribe line area (SL) along said first direction is chosen to be mirror-symmetrical with respect to the position (X1) of the marker (MX) along said first direction, by applying said mirror operation around a mirror line (MP), said mirror line (MP) being a symmetry line of the rectangular envelope of the die (D) in said second direction.

3. Method according to claim 1 or 2, wherein said mirrored marker (MX') is created in a same lithographic step as said marker (MX).

4. Method according to claim 3, the semiconductor layer having a backside, wherein the method comprises a fully aligned processing of the backside of the semiconductor layer, using lithographic alignment on the mirrored marker (MX').

5. Method according to claim 4, wherein the fully aligned processing comprises: forming of at least one component of a heat sink, of an RF device, of a memory device, of an analog device, or of a high-voltage device.

6. Method according to claim 4, wherein the fully aligned processing comprises: forming of at least one component of an opto-electronic device.

7. Method according to claim 4, wherein the fully aligned processing comprises: forming of at least one component of a micro-mechanic device.

8. Method according to any one of the preceding claims, wherein the new substrate is a non-Si substrate or a Si substrate with a high resistivity.

9. Semiconductor device manufactured in accordance with any one of the preceding claims.

10. Semiconductor device according to claim 9, wherein the semiconductor device comprises at least one double gate transistor manufactured by SOI processing.
